(19) Europäisches Patentamt
European Patent Office
Office européen des brevets

(11) EP 4 079 790 A1

(12) # EUROPEAN PATENT APPLICATION

(43) Date of publication:
26.10.2022 Bulletin 2022/43

(21) Application number: 22168391.5

(22) Date of filing: 14.04.2022

(51) International Patent Classification (IPC):
*C08G 73/10* (2006.01) *B32B 15/08* (2006.01)
*B32B 27/06* (2006.01) *C08J 9/28* (2006.01)
*H05K 1/03* (2006.01)

(52) Cooperative Patent Classification (CPC):
(C-Sets available)
**B32B 15/20; B32B 5/18; B32B 15/046; B32B 15/08; B32B 27/281; C08G 73/1042; C08G 73/1071; C08G 73/16; C08J 9/286; C08L 79/08; H05K 1/0346;** B32B 2250/40; B32B 2266/0214; B32B 2457/00; C08L 2203/16

(Cont.)

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **19.04.2021 JP 2021070657**

(71) Applicant: **Nitto Denko Corporation**
**Ibaraki-shi**
**Osaka 567-8680 (JP)**

(72) Inventor: **MISHIMA, Kei**
**Osaka, 567-8680 (JP)**

(74) Representative: **Gill Jennings & Every LLP**
**The Broadgate Tower**
**20 Primrose Street**
**London EC2A 2ES (GB)**

(54) **POROUS POLYIMIDE FILM**

(57) [Problem]

To provide a porous polyimide film having a low dielectric loss tangent.

[Solving Means]

A porous polyimide film is a reaction product of a diamine component and an acid dianhydride component. The diamine component contains an aromatic diamine represented by the following formula (1).

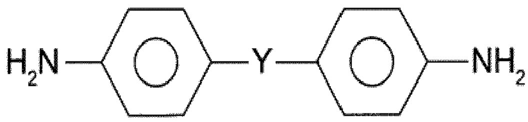

(1)

(In formula, Y represents at least one selected from the group consisting of a single bond, -COO-, -S-, $-CH(CH_3)-$, $-C(CH_3)_2-$, -CO-, -NH-, and -NHCO-.) The porosity is 50% or more.

EP 4 079 790 A1

FIG. 1

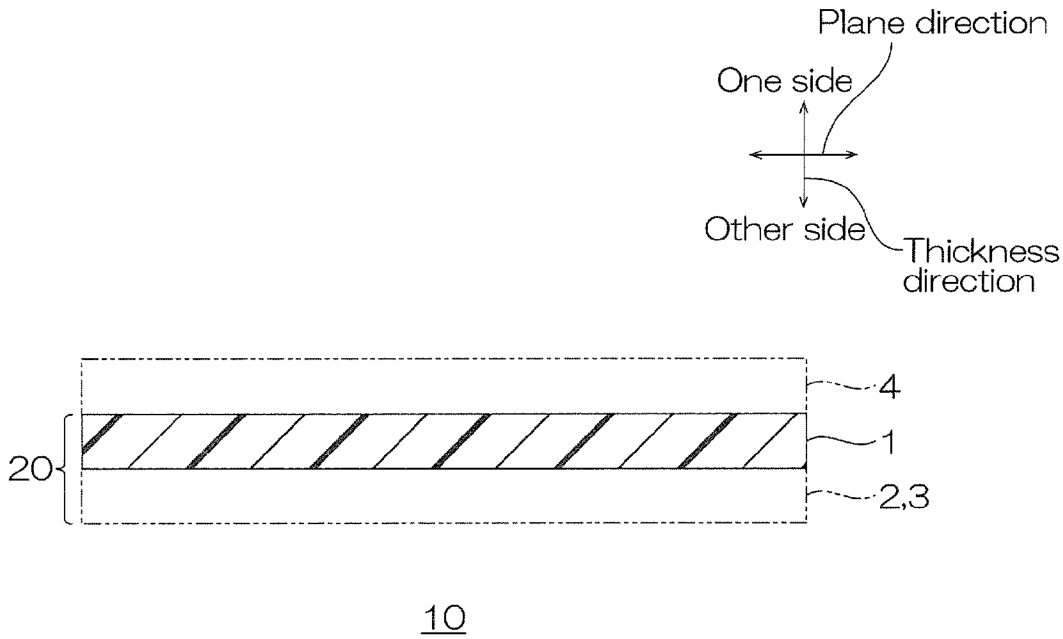


(52) Cooperative Patent Classification (CPC): (Cont.)

C-Sets
**C08L 79/08, C08K 5/3445, C08L 27/18, C08L 71/03**

## Description

TECHNICAL FIELD

The present invention relates to a porous polyimide film.

BACKGROUND ART

A porous polyimide film which is a reaction product of a diamine component and an acid dianhydride component has been known (ref: for example, Patent Document 1 below). In Example of Patent Document 1, the diamine component contains a phenylenediamine (PDA) and an oxydianiline (ODA).

Citation List

Patent Document

Patent Document 1: WO2018/186486

SUMMARY OF THE INVENTION

PROBLEM TO BE SOLVED BY THE INVENTION

A low dielectric loss tangent is required for a porous polyimide film. However, there is a limit in lowering the dielectric loss tangent of the porous polyimide film described in Patent Document 1.

The present invention provides a porous polyimide film having a low dielectric loss tangent.

MEANS FOR SOLVING THE PROBLEM

The present invention (1) includes a porous polyimide film being a reaction product of a diamine component and an acid dianhydride component, and having a porosity of 50% or more, wherein the diamine component contains an aromatic diamine represented by the following formula (1).

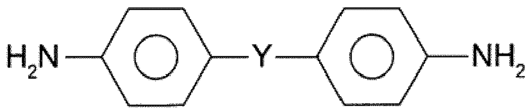

(1)

(In formula, Y represents at least one selected from the group consisting of a single bond, -COO-, -S-, $-CH(CH_3)-$, $-C(CH_3)_2-$, -CO-, -NH-, and -NHCO-.)

The present invention (2) includes the porous polyimide film described in (1) having a dielectric loss tangent at 10 GHz of 0.0028 or less.

The present invention (3) includes the porous polyimide film described in (1) or (2) having a porosity of 95% or less.

EFFECT OF THE INVENTION

In the porous polyimide film of the present invention, since the diamine component contains the aromatic diamine represented by formula (1) and has the porosity of 50% or more, the dielectric loss tangent of the porous polyimide film is low.

BRIEF DESCRIPTION OF THE DRAWINGS

FIG. 1 shows a cross-sectional view of one embodiment of a porous polyimide film of the present invention.

DESCRIPTION OF EMBODIMENTS

<Porous Polyimide Film>

A porous polyimide film of the present invention is described. The porous polyimide film has a thickness. The porous polyimide film extends in a plane direction. The plane direction is perpendicular to a thickness direction.

The porous polyimide film is a porous product (foaming product). The porous polyimide film has, for example, a closed-cell structure and/or an open cell structure.

<Porosity>

The porous polyimide film has a porosity of 50% or more.

When the porosity of the porous polyimide film is below 50%, it is not possible to sufficiently lower a dielectric loss tangent of the porous polyimide film. Specifically, when the porosity of the porous polyimide film is below 50%, even though a diamine component as a raw material contains a specific aromatic diamine to be described later, it is not possible to sufficiently lower the dielectric loss tangent of the porous polyimide film.

The porous polyimide film has a porosity of preferably 60% or more, more preferably 70% or more, further more preferably 75% or more.

The porous polyimide film has a porosity of, for example, 95% or less, preferably 90% or less, more preferably 85% or less, further more preferably 75% or less, particularly preferably 70% or less. When the porosity of the porous polyimide film is the above-described upper limit or less, mechanical strength of the porous polyimide film is ensured, and handling properties are excellent.

The porosity of the porous polyimide film is determined by insertion of the dielectric constant into the following formula.

$$\text{Dielectric constant of porous polyimide film} = \text{dielectric constant of air} \times \text{porosity} + \text{dielectric constant of polyimide resin} \times (1 - \text{porosity})$$

The dielectric constant of the porous polyimide film inserted into the above-described formula is measured at a frequency of 10 GHz with a resonator. Also, the dielectric constant is measured at a temperature of 22°C and relative humidity of 50%.

<Properties Other Than Porosity>

The porous polyimide film has an average pore size of, for example, 10 μm or less, preferably 5 μm or less, more preferably 4 μm or less, and for example, 0.1 μm or more, preferably 1 μm or more, more preferably 2 μm or more. The average pore size is measured by image analysis of a cross-sectional SEM image.

The dielectric constant of the porous polyimide film at 10 GHz is not limited. The porous polyimide film has a dielectric constant at 10 GHz of, for example, 2.50 or less, preferably 2.00 or less, more preferably 1.80 or less, further more preferably 1.75 or less, particularly preferably 1.70 or less, most preferably 1.60 or less. Also, the porous polyimide film has a dielectric constant at 10 GHz of above 1.00. The dielectric constant of the porous polyimide film is measured using a resonator.

The porous polyimide film has a dielectric loss tangent at 10 GHz of, for example, 0.0028 or less, preferably 0.0025 or less, more preferably 0.0020 or less, further more preferably 0.0018 or less, particularly preferably 0.0017 or less, most preferably 0.0016 or less. When the dielectric loss tangent of the porous polyimide film is the above-described upper limit or less, it is preferably used for, for example, wireless communication of the fifth generation (5G) standard, and/or a high-speed flexible printed board (FPC) as a porous polyimide film having a low dielectric loss tangent.

Also, the porous polyimide film has a dielectric loss tangent at 10 GHz of above 0.0000. The dielectric loss tangent of the porous polyimide film is measured using a resonator.

A thickness of the porous polyimide film is not limited. The porous polyimide film has a thickness of, for example, 2 μm or more, preferably 5 μm or more, and for example, 1000 μm or less, preferably 500 μm or less.

<Raw Material for Porous Polyimide Film>

The porous polyimide film of the present invention is a reaction product of a diamine component and an acid dianhydride component. In other words, a raw material for the porous polyimide film contains a diamine component and

an acid dianhydride component.

<Diamine Component>

The diamine component contains an aromatic diamine. The aromatic diamine is represented by the following formula (1).

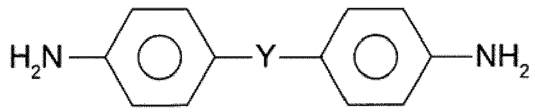

(1)

(In formula, Y represents at least one selected from the group consisting of a single bond, -COO-, -S-, $-CH(CH_3)-$, $-C(CH_3)_2-$, -CO-, -NH-, and -NHCO-.)

<Kind of Aromatic Diamine>

Specifically, examples of the diamine component include 4,4'-diaminodiphenyl in which Y is a single bond, 4-aminophenyl-4-aminobenzoate in which Y is -COO-, bis(4-aminophenyl)sulfide in which Y is -S-, 4,4'-diaminodiphenylethane in which Y is $-CH(CH_3)-$, 4,4'-diaminodiphenyl propane in which Y is $-C(CH_3)_2-$, 4,4'-diaminobenzophenone in which Y is -CO-, 4,4'-diaminophenyleneamine in which Y is -NH-, and 4,4'-diaminobenzoanilide in which Y is -NHCO-. Preferably, from the viewpoint of further lowering the dielectric loss tangent of the porous polyimide film, a 4-aminophenyl-4-aminobenzoate is used. The 4-aminophenyl-4-aminobenzoate may be simply abbreviated as APAB. The above-described aromatic diamines may be used alone or in combination. Preferably, APAB is used alone.

On the other hand, when the diamine component does not contain the above-described aromatic diamine, it is not possible to sufficiently lower the dielectric loss tangent of the porous polyimide film. Specifically, when the diamine component does not contain the above-described aromatic diamine, even though the porosity is as high as 50% or more, it is not possible to sufficiently lower the dielectric loss tangent of the porous polyimide film.

A mole fraction of the aromatic diamine in the diamine component is, for example, 5 mol% or more, preferably 10 mol% or more, more preferably 15 mol% or more, and for example, 75 mol% or less, preferably 60 mol% or less, more preferably 40 mol% or less.

<Another Diamine Component>

Another diamine component may contain, for example, a second diamine and a third diamine in addition to the above-described aromatic diamine.

<Second Diamine>

The second diamine includes a single aromatic ring. Examples of the second diamine include phenylenediamine, dimethylbenzenediamine, and ethylmethylbenzenediamine. From the viewpoint of mechanical strength, preferably, a phenylenediamine is used. Examples of the phenylenediamine include o-phenylenediamine, m-phenylenediamine, and p-phenylenediamine. As the phenylenediamine, preferably, a p-phenylenediamine is used. The p-phenylenediamine may be simply abbreviated as PDA.

A mole fraction of the second diamine in the diamine component is, for example, 10 mol% or more, preferably 20 mol% or more, more preferably 30 mol% or more, and for example, 80 mol% or less, preferably 70 mol% or less, more preferably 65 mol% or less.

<Third Diamine>

The third diamine includes a plurality of aromatic rings and an ether bond disposed between them. An example of the third diamine includes an oxydianiline. Examples of the oxydianiline include 3,4'-oxydianiline and 4,4'-oxydianiline. From the viewpoint of mechanical strength, preferably, a 4,4'-oxydianiline (also known as 4,4'-diaminodiphenylether) is used. The 4,4'-oxydianiline may be simply abbreviated as ODA.

A mole fraction of the third diamine in the diamine component is, for example, 5 mol% or more, preferably 10 mol% or more, and for example, 40 mol% or less, preferably 30 mol% or less.

In addition, a part by mole of the above-described aromatic diamine with respect to 100 parts by mole of the total sum of the second diamine and the third diamine is, for example, 5 parts by mole or more, preferably 10 parts by

mole or more, more preferably 20 parts by mole or more, and for example, 100 parts by mole or less, preferably 50 parts by mole or less, more preferably 30 parts by mole or less.

<Acid Dianhydride Component>

The acid dianhydride component contains, for example, an acid dianhydride including an aromatic ring. An example of the acid dianhydride including an aromatic ring includes an aromatic tetracarboxylic acid dianhydride. Examples of the aromatic tetracarboxylic acid dianhydride include benzenetetracarboxylic acid dianhydride, benzophenone tetracarboxylic acid dianhydride, biphenyltetracarboxylic acid dianhydride, biphenylsulfone tetracarboxylic acid dianhydride, and naphthalenetetracarboxylic acid dianhydride.

An example of the benzenetetracarboxylic acid dianhydride includes a benzene-1,2,4,5-tetracarboxylic acid dianhydride (also known as pyromellitic acid dianhydride). An example of the benzophenone tetracarboxylic acid dianhydride includes a 3,3'-4,4'-benzophenone tetracarboxylic acid dianhydride. Examples of the biphenyltetracarboxylic acid dianhydride include 3,3'-4,4'-biphenyltetracarboxylic acid dianhydride, 2,2'-3,3'-biphenyltetracarboxylic acid dianhydride, 2,3,3',4'-biphenyltetracarboxylic acid dianhydride, and 3,3',4,4'-diphenylethertetracarboxylic acid dianhydride. An example of the biphenylsulfone tetracarboxylic acid dianhydride includes a 3,3',4,4'-biphenylsulfone tetracarboxylic acid dianhydride. Examples of the naphthalenetetracarboxylic acid dianhydride include 2,3,6,7-naphthalenetetracarboxylic acid dianhydride, 1,2,5,6-naphthalenetetracarboxylic acid dianhydride, 1,2,4,5-naphthalenetetracarboxylic acid dianhydride, and 1,4,5,8-naphthalenetetracarboxylic acid dianhydride. These may be used alone or in combination. As the acid dianhydride component, from the viewpoint of mechanical strength, preferably, a biphenyltetracarboxylic acid dianhydride is used, more preferably, a 3,3'-4,4'-biphenyltetracarboxylic acid dianhydride is used. The 3,3'-4,4'-biphenyltetracarboxylic acid dianhydride may be simply abbreviated as BPDA.

A mole amount of amino groups ($-NH_2$) of the diamine component and a mole amount of acid anhydride groups (-CO-O-CO-) of the acid dianhydride component are, for example, an equal amount.

Next, a method for producing a porous polyimide film 1 is described with reference to FIG. 1.

In this method, for example, first, a substrate film 2 made of a metal (parentheses and phantom line) is prepared. The substrate film 2 extends in the plane direction. Examples of the metal include copper, iron, silver, gold, aluminum, nickel, and alloys of these (stainless steel and bronze). As the metal, preferably, copper is used. The substrate film 2 has a thickness of, for example, 0.1 $\mu$m or more, preferably 1 $\mu$m or more, and for example, 100 $\mu$m or less, preferably 50 $\mu$m or less.

Next, a varnish containing a precursor of a polyimide resin, a porosity forming agent, a nucleating agent, and a solvent is prepared, and then, the varnish is applied to one surface in the thickness direction of the substrate film 2 to form a coating film. A kind, a mixing ratio, and the like of the porosity forming agent, the nucleating agent, and the solvent in the varnish are, for example, described in WO2018/186486.

The precursor of the polyimide resin is a reaction product of the diamine component and the acid dianhydride component described above. To prepare the precursor of the polyimide resin, the above-described diamine component, the above-described acid dianhydride component, and a solvent are blended to prepare a varnish, and the varnish is heated to prepare a precursor solution. Subsequently, a nucleating agent and a porosity forming agent are blended into the precursor solution to prepare a porous precursor solution.

Thereafter, the porous precursor solution is applied to one surface in the thickness direction of the substrate film 2 to form a coating film.

Thereafter, the coating film is dried by heating to form a precursor film. By the above-described heating, the precursor film having a phase separation structure of a polyimide resin precursor and the porosity forming agent with the nucleating agent as a core is prepared, while the removal of the solvent proceeds.

Thereafter, for example, the porosity forming agent is extracted (pulled out or removed) from the precursor film by a supercritical extraction method using supercritical carbon dioxide as a solvent.

Thereafter, the precursor film is cured by heating to form the porous polyimide film 1 made of the polyimide resin. The porous polyimide film 1 is formed on one surface in the thickness direction of the substrate film 2.

Thereafter, if necessary, as shown by a solid line of FIG. 1. the substrate film 2 is removed. For example, the substrate film 2 is dissolved using a stripping solution. An example of the stripping solution includes $FeCl_3$. Thus, the porous polyimide film 1 is obtained. To produce a metal layer laminate board 10 to be described later, the above-described substrate film 2 is not removed and left as a first metal layer 3.

<Application>

Next, as shown by a phantom line and the solid line of FIG. 1, the metal layer laminate board 10 including the porous polyimide film 1 is described. The metal layer laminate board 10 includes the porous polyimide film 1 and two metal layers 3 and 4 shown by the phantom line.

The porous polyimide film 1 is provided in the metal layer laminate board 10. That is, the porous polyimide film 1 is used for lamination of the two metal layers 3 and 4 to be described next.

The two metal layers 3 and 4 include the first metal layer 3 and a second metal layer 4. The first metal layer 3 is disposed on the other surface in the thickness direction of the porous polyimide film 1. Examples of a material for the first metal layer 3 include metals illustrated in the substrate film 2. Preferably, copper is used. The first metal layer 3 has a thickness of, for example, 0.1 $\mu$m or more, preferably 1 $\mu$m or more, and for example, 100 $\mu$m or less, preferably 50 $\mu$m or less.

The second metal layer 4 is disposed on one surface in the thickness direction of the porous polyimide film 1. The second metal layer 4 may be also disposed on one surface in the thickness direction of the porous polyimide film 1 via an adhesive layer which is not shown. Examples of a material for the second metal layer 4 include metals illustrated in the substrate film 2. A thickness of the second metal layer 4 is the same as that of the first metal layer 3.

A method for producing the metal layer laminate board 10 is described. First, the second metal layer 4 is disposed on one surface in the thickness direction of a laminate 20 which is in the middle of production and includes the substrate film 2 and the porous polyimide film 1. On the other hand, since the substrate film 2 is made of a metal, it is left as it is as the first metal layer 3 (is diverted to the first metal layer 3). Thus, the metal layer laminate board 10 including the porous polyimide film 1, and the second metal layer 4 and the first metal layer 3 disposed on one surface and the other surface, respectively, in the thickness direction thereof is obtained.

Thereafter, the first metal layer 3 and the second metal layer 4 are, for example, formed into a pattern by etching and the like.

The metal layer laminate board 10 is pressed before, during and/or after the formation of the above-described pattern in accordance with its application and purpose. Specifically, the metal layer laminate board 10 is thermally pressed.

The metal layer laminate board 10 is, for example, used for wireless communication of the fifth generation (5G) standard, and/or a high-speed flexible printed board (FPC).

(Function and Effect of One Embodiment)

In the above-described porous polyimide film 1, since the diamine component contains an aromatic diamine represented by formula (1) and the porosity thereof is 50% or more, the dielectric loss tangent of the porous polyimide film is low.

When the dielectric loss tangent of the porous polyimide film 1 is 0.0028 or less, it is preferably used for, for example, wireless communication of the fifth generation (5G) standard, and/or a high-speed flexible printed board (FPC) as the porous polyimide film 1 having a low dielectric loss tangent.

Further, when the porosity of the porous polyimide film 1 is 95% or less, the mechanical strength of the porous polyimide film is excellent.

Examples

Next, the present invention is further described based on Examples and Comparative Examples below. The present invention is however not limited by these Examples and Comparative Examples. The specific numerical values in mixing ratio (content ratio), property value, and parameter used in the following description can be replaced with upper limit values (numerical values defined as "or less" or "below") or lower limit values (numerical values defined as "or more" or "above") of corresponding numerical values in mixing ratio (content ratio), property value, and parameter described in the above-described "DESCRIPTION OF EMBODIMENTS".

<Example 1>

A reaction device equipped with a stirrer and a thermometer was charged with 64.88 g (0.60 mol) of PDA (second diamine), 40.05 g (0.20 mol) of ODA (third diamine), and 45.65 g (0.20 mol) of APAB (aromatic diamine represented by formula (1) and in which Y- is -COO-); and 2300 g of an N-methyl-2-pyrrolidone (NMP) as a solvent was added thereto and stirred at 40°C for 20 minutes to prepare an NMP solution of PDA, ODA and APAB. The NMP solution contained 1.00 mol of a diamine component.

Next, 294.2 g (1.00 mol) of a 3,3'-4,4'-biphenyltetracarboxylic acid dianhydride (BPDA) was gradually added to the above-described NMP solution, furthermore, 18 g of an N-methyl-2-pyrrolidone (NMP) was added to increase the temperature to 80°C, and thereafter, the resulting mixture was stirred for 10 hours to obtain a polyimide precursor solution.

As a nucleating agent, 3 parts by mass of a PTFE powder having a median diameter of 1 $\mu$m or less; as a porosity forming agent, 150 parts by mass of a polyoxyethylene dimethyl ether having a weight average molecular weight of 400 (manufactured by NOF CORPORATION, grade: MM400); and 4 parts by mass of a 2-methylimidazole (manufactured by SHIKOKU CHEMICALS CORPORATION, 2Mz-H) were added to 100 parts by mass of the solid content of

the polyimide precursor solution to obtain a porous precursor solution. The obtained porous precursor solution was applied to the substrate film 2 made of copper to form a coating film. Thereafter, the coating film was dried at 135°C for 15 minutes to fabricate a precursor film.

By immersing the precursor film into carbon dioxide pressurized to 30 MPa at 60°C and by circulating it for four hours, extraction removal of the porosity forming agent, phase separation of the remaining NMP, and formation of pores were promoted. Thereafter, the carbon dioxide was reduced in pressure.

Subsequently, the precursor film was heated at a temperature of 390°C for about 185 minutes under vacuum to promote removal and imidization of the remaining component, thereby obtaining the porous polyimide film 1 disposed on one surface in the thickness direction of the substrate film 2. Thereafter, the substrate film 2 and the porous polyimide film 1 (the laminate 20) were immersed in a $FeCl_3$ solution, and the substrate film 2 was removed.

In Table 1, the number of g and the number of parts by mass of each component are described. In Table 2, the mole fractions of the diamine component and the acid dianhydride component are described.

<Examples 2 to 6 and Comparative Examples 1 to 3>

The porous polyimide film 1 was produced in the same manner as in Example 1. However, the formulation was changed in accordance with Tables 1 and 2.

<Evaluation>

The following items were measured for each of the porous polyimide films 1 of Examples 2 to 6 and Comparative Examples 1 to 3. The results (excluding an average porosity) are described in Table 2.

<Dielectric Constant and Dielectric Loss Tangent>

Each of the dielectric constant and the dielectric loss tangent of the porous polyimide film 1 was measured at a frequency of 10 GHz with a resonator. The dielectric constant and the dielectric loss tangent were measured at a temperature of 22°C and relative humidity of 50%.

<Porosity>

A porosity of the porous polyimide film 1 was determined by inserting the dielectric constant obtained as the description above into the following formula.

Dielectric constant of porous polyimide film= dielectric constant of air× porosity+ dielectric constant of polyimide resin× (1- porosity)

<Average Pore Size>

An average pore size of each of the porous polyimide films 1 of Example 1 and Comparative Example 1 was measured by image analysis of a cross-sectional SEM image.

As a result, the porous polyimide film 1 of Example 1 had an average pore size of 3.6 μm. On the other hand, the porous polyimide film 1 of Comparative Example 1 had an average pore size of 5.3 μm.

[Table 1]

Table 1

| Formulation | | | Ex. 1 | Ex. 2 | Ex. 3 | Ex. 4 | Ex. 5 | Ex. 6 | Comparative Ex. 1 | Comparative Ex. 2 | Comparative Ex. 3 |
|---|---|---|---|---|---|---|---|---|---|---|---|
| Diamine Component | Second Diamine | PDA (g) | 64.88 | 64.88 | 64.88 | 2.16 | 1.08 | 0.65 | 129.77 | 64.88 | 64.88 |
| | Third Diamine | ODA (g) | 40.05 | 40.05 | 40.05 | 2.00 | 6.01 | 4.21 | 60.07 | 40.05 | 40.05 |
| | Aromatic Diamine | APAB (g) | 45.65 | 45.65 | 45.65 | 4.57 | 2.28 | 7.53 | - | 45.65 | 45.65 |
| Acid Dianhydride Component | | BPDA (g) | 294.22 | 294.22 | 294.22 | 14.71 | 14.71 | 17.65 | 441.33 | 294.22 | 294.22 |
| Solvent | | NMP (g) | 2300 +18 | 2300 +18 | 2300 +18 | 113 +8 | 113 +10 | 144 +11 | 3264 +72 | 2300 +18 | 2300 +18 |
| Porosity Forming Agent | | Polyoxyethylene Dimethyl Ether (Number of parts by mass to 100 parts of Solid Content of Polyimide Precursor Solution | 150 | 200 | 130 | 150 | 150 | 150 | 200 | 30 | 20 |

[Table 2]

Table 2

| Formulation | | | Ex. 1 | Ex. 2 | Ex. 3 | Ex. 4 | Ex. 5 | Ex. 6 | Comparative Ex. 1 | Comparative Ex. 2 | Comparative Ex. 3 |
|---|---|---|---|---|---|---|---|---|---|---|---|
| Diamine Component | Second Diamine | PDA (mol%) | 60 | 60 | 60 | 40 | 20 | 10 | 80 | 60 | 60 |
| | Third Diamine | ODA (mol%) | 20 | 20 | 20 | 20 | 60 | 35 | 20 | 20 | 20 |
| | Aromatic Diamine | APAB (mol%) | 20 | 20 | 20 | 40 | 20 | 55 | - | 20 | 20 |
| Acid Dianhydride Component | | BPDA (mol%) | 100 | 100 | 100 | 100 | 100 | 100 | 100 | 100 | 100 |
| Porosity (%) | | | 69 | 80 | 60 | 70 | 70 | 70 | 81 | 32 | 14 |
| Dielectric Constant | | | 1.70 | 1.49 | 1.98 | 1.74 | 1.72 | 1.77 | 1.49 | 2.65 | 3.09 |
| Dielectric Loss Tangent | | | 0.0022 | 0.0016 | 0.0022 | 0.0017 | 0.0018 | 0.0020 | 0.0029 | 0.0033 | 0.0034 |

While the illustrative embodiments of the present invention are provided in the above description, such is for illustrative purpose only and it is not to be construed as limiting the scope of the present invention. Modification and variation of the present invention that will be obvious to those skilled in the art is to be covered by the following claims.

Description of Reference Numerals

1 Porous polyimide film

**Claims**

1. A porous polyimide film being:

   a reaction product of a diamine component and an acid dianhydride component, and
   having a porosity of 50% or more, wherein
   the diamine component contains an aromatic diamine represented by the following formula (1).

   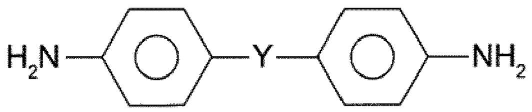 (1)

   (In formula, Y represents at least one selected from the group consisting of a single bond, -COO-, -S-, $-CH(CH_3)-$, $-C(CH_3)_2-$, -CO-, -NH-, and -NHCO-.)

2. The porous polyimide film according to claim 1 having a dielectric loss tangent at 10 GHz of 0.0028 or less.

3. The porous polyimide film according to claim 1 or 2 having a porosity of 95% or less.

FIG. 1

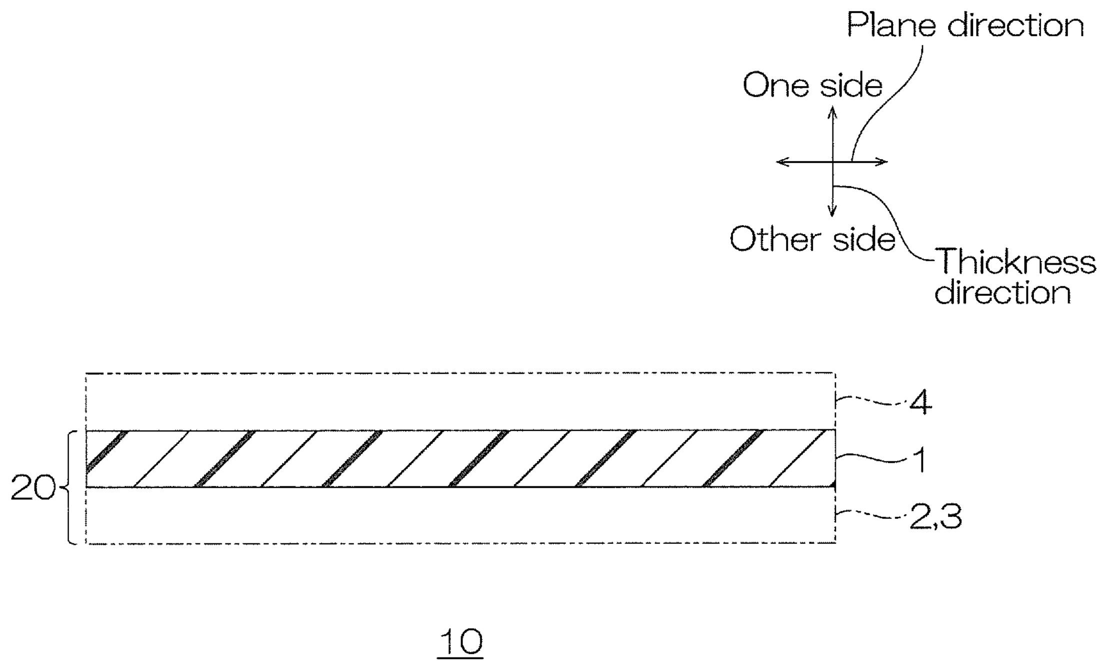
Plane direction
One side
Other side
Thickness direction
4
1
2,3
20
10

Europäisches Patentamt
European Patent Office
Office européen des brevets

# EUROPEAN SEARCH REPORT

Application Number
EP 22 16 8391

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | ZHONG YA ET AL: "Preparation and Characterization of Polyimide Aerogels with a Uniform Nanoporous Framework", LANGMUIR, vol. 34, no. 36, 17 August 2018 (2018-08-17), pages 10529-10536, XP055951863, US ISSN: 0743-7463, DOI: 10.1021/acs.langmuir.8b01756 * scheme 1; experimental section; page 10530 - page 10531; table 1 * ----- | 1-3 | INV. C08G73/10 B32B15/08 B32B27/06 C08J9/28 H05K1/03 |
| X | CN 105 820 368 B (CHANGCHUN INST APPLIED CHEMISTRY CAS) 27 November 2018 (2018-11-27) * examples 3, 7 * ----- | 1-3 | |
| X | CN 102 816 431 B (JIANGXI XIANCAI NANOFIBERS TECHNOLOGY CO LTD) 2 July 2014 (2014-07-02) * examples 1-5 * ----- | 1-3 | TECHNICAL FIELDS SEARCHED (IPC) |
| X | US 9 209 444 B2 (HOU HAOQING [CN]; CHENG CHUYUN [CN] ET AL.) 8 December 2015 (2015-12-08) * column 5, line 35 - line 40; examples 2, 7 * ----- | 1-3 | C08G B32B C08J H05K |
| A | US 2019/263996 A1 (NAKAMURA MASAYOSHI [JP] ET AL) 29 August 2019 (2019-08-29) * table 1 * ----- | 1-3 | |
| A | CN 109 337 072 A (JIANGYIN JUNCHI COMPOSITE MAT CO LTD) 15 February 2019 (2019-02-15) * examples 1-12 * ----- -/-- | 1-3 | |

The present search report has been drawn up for all claims

1

| Place of search | Date of completion of the search | Examiner |
|---|---|---|
| Munich | 17 August 2022 | Arz, Marius |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

page 1 of 2

Europäisches Patentamt
European Patent Office
Office européen des brevets

# EUROPEAN SEARCH REPORT

Application Number
EP 22 16 8391

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | Lira-Olivares J ET AL: "Determination of porosity by dielectric permittivity measurements in porous ceramics", Revista Latinoamericana de Metalurgia y Materiales, 1 December 2000 (2000-12-01), pages 68-79, XP055951932, Retrieved from the Internet: URL:https://www.researchgate.net/publication/216468549_Determination_of_porosity_by_dielectric_permittivity_measurements_in_porous_ceramics/link/6176b399eef53e51e1e5682c/download [retrieved on 2022-08-16] * sections 4 and 7; equation 9; page 71 - page 73 * ----- | 1-3 | |

TECHNICAL FIELDS SEARCHED (IPC)

The present search report has been drawn up for all claims

1

| Place of search | Date of completion of the search | Examiner |
|---|---|---|
| Munich | 17 August 2022 | Arz, Marius |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

page 2 of 2

## ANNEX TO THE EUROPEAN SEARCH REPORT ON EUROPEAN PATENT APPLICATION NO. EP 22 16 8391

This annex lists the patent family members relating to the patent documents cited in the above-mentioned European search report. The members are as contained in the European Patent Office EDP file on
The European Patent Office is in no way liable for these particulars which are merely given for the purpose of information.

17-08-2022

| Patent document cited in search report | Publication date | Patent family member(s) | Publication date |
|---|---|---|---|
| CN 105820368 B | 27-11-2018 | NONE | |
| CN 102816431 B | 02-07-2014 | NONE | |
| US 9209444 B2 | 08-12-2015 | CN 102383222 A | 21-03-2012 |
| | | CZ 306811 B6 | 19-07-2017 |
| | | DE 112010005835 T5 | 20-06-2013 |
| | | JP 2013544323 A | 12-12-2013 |
| | | KR 20130086350 A | 01-08-2013 |
| | | US 2013164629 A1 | 27-06-2013 |
| | | WO 2012027917 A1 | 08-03-2012 |
| US 2019263996 A1 | 29-08-2019 | CN 109496222 A | 19-03-2019 |
| | | EP 3489288 A1 | 29-05-2019 |
| | | JP 6567590 B2 | 28-08-2019 |
| | | JP 2018021171 A | 08-02-2018 |
| | | JP 2019199614 A | 21-11-2019 |
| | | KR 20190029649 A | 20-03-2019 |
| | | KR 20210071103 A | 15-06-2021 |
| | | TW 201811884 A | 01-04-2018 |
| | | TW 201936741 A | 16-09-2019 |
| | | US 2019263996 A1 | 29-08-2019 |
| | | WO 2018020745 A1 | 01-02-2018 |
| CN 109337072 A | 15-02-2019 | NONE | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- WO 2018186486 A